# FASCICULE DE BREVET EUROPEEN

(11) **EP 4 400 855 B1**
(45) Date de publication et mention de la délivrance du brevet: **12.11.2025**
(21) Numéro de dépôt: 24150376.2
(22) Date de dépôt: 04.01.2024
(51) Int. Cl.: G01R 31/374, E06B 9/24, G01R 31/388, E06B 9/68

(54) **PROCEDE ET DISPOSITIF DE DETERMINATION D'UN NIVEAU DE CHARGE D'UNE BATTERIE ALIMENTANT EN ENERGIE ELECTRIQUE UN DISPOSITIF D'OCCULTATION D'UNE OUVERTURE D'UNE PIECE D'UN BATIMENT OU D'UNE PROTECTION SOLAIRE**
VERFAHREN UND VORRICHTUNG ZUR BESTIMMUNG EINES LADEZUSTANDES EINER BATTERIE ZUR ENERGIEVERSORGUNG EINER VERDUNKELUNGSVORRICHTUNG FÜR FENSTER ODER EINES SONNENSCHUTZTEILS
METHOD AND DEVICE FOR DETERMINING A LEVEL OF CHARGE OF A BATTERY SUPPLYING ELECTRICAL ENERGY TO A DEVICE FOR WINDOW SHADING OR SOLAR PROTECTION

(30) Priorité: 16.01.2023 FR 2300383
(43) Date de publication de la demande: 17.07.2024
(73) Titulaire: Delta Dore, 35270 Bonnemain (FR)
(72) Inventeur: CHABANNES, André, 35270 BONNEMAIN (FR); LAMBERT, David, 35270 BONNEMAIN (FR)
(74) Mandataire: Cabinet Le Guen Maillet

(56) Documents cités:
- EP-B1- 3 091 170
- WO-A1-2022/129530
- FR-A1- 3 064 128
- US-A1- 2020 371 163

## Description

### DOMAINE TECHNIQUE

La présente invention concerne le domaine des systèmes d'occultation d'une ouverture d'une pièce d'un bâtiment ou de protection solaire alimentés par une batterie.

### ETAT DE LA TECHNIQUE ANTERIEURE

Un dispositif d'occultation ou de protection solaire est mis en mouvement grâce à un moteur et un contrôleur du moteur. Le moteur et le contrôleur nécessitent d'être alimentés électriquement pour effectuer une telle mise en mouvement. L'alimentation électrique du moteur et du contrôleur grâce à des énergies renouvelables se développe. Par exemple, le moteur et le contrôleur peuvent être alimentés par une batterie chargée par des éléments photovoltaïques.

Pour garantir un usage effectif du moteur du dispositif d'occultation, la batterie doit être chargée en énergie électrique. Lors de l'utilisation du dispositif d'occultation, de l'énergie est consommée lors de la mise en mouvement du dispositif d'occultation. A certaines périodes d'une journée, telles que la nuit, les éléments photovoltaïques ne peuvent délivrer de l'énergie électrique à la batterie. Il en est de même lorsque les conditions atmosphériques empêchent ou réduisent le rayonnement lumineux sur les éléments photovoltaïques.

Il est apparu un besoin de fournir une information sur le niveau de charge de la batterie aux utilisateurs de système d'occultation ou de protection solaire.

EP3091170 B1 décrit un procédé de détermination de niveau de charge d'une batterie alimentant en énergie électrique un dispositif d'occultation.

### EXPOSE DE L'INVENTION

La présente invention vise à résoudre les problèmes susmentionnés en proposant un procédé de détermination d'un niveau de charge d'une batterie alimentant en énergie électrique un dispositif d'occultation d'une ouverture d'une pièce d'un bâtiment ou d'une protection solaire, la batterie étant alimentée en énergie électrique par des éléments photovoltaïques, caractérisé en ce que le procédé comporte les étapes effectuées par un dispositif de contrôle de l'alimentation électrique du dispositif d'occultation de l'ouverture ou de la protection solaire de :
- mesure d'une température dans un coffre comprenant le dispositif de contrôle de l'alimentation électrique,
- vérification si la température mesurée est inférieure ou égale à une unique température prédéterminée,
- détermination d'une pluralité de valeurs de seuils de charge de la batterie en fonction de la vérification,
- mesure d'une tension aux bornes de la batterie,
- comparaisons de la tension mesurée à au moins une partie des seuils de charge et/ou à des seuils de décharge de la batterie, les seuils de décharge de la batterie ayant des valeurs prédéterminées et indépendantes de la température mesurée,
- détermination du niveau de charge de la batterie en fonction des comparaisons. L'invention concerne aussi un dispositif de détermination d'un niveau de charge d'une batterie alimentant en énergie électrique un dispositif d'occultation d'une ouverture d'une pièce d'un bâtiment ou d'une protection solaire, la batterie étant alimentée en énergie électrique par des éléments photovoltaïques, caractérisé en ce que le dispositif est compris dans un dispositif de contrôle de l'alimentation électrique du dispositif d'occultation de l'ouverture ou de la protection solaire et comporte :
   - des moyens de mesure d'une température dans un coffre comprenant le dispositif de contrôle de l'alimentation électrique,
   - des moyens de vérification si la température mesurée est inférieure ou égale à une unique température prédéterminée,
   - des moyens de détermination d'une pluralité de valeurs de seuils de charge de la batterie en fonction de la vérification,
   - des moyens de mesure d'une tension aux bornes de la batterie,
   - des moyens de comparaisons de la tension mesurée à au moins une partie des seuils de charge et/ou à des seuils de décharge de la batterie, les seuils de décharge de la batterie ayant des valeurs prédéterminées et indépendantes de la température mesurée,
   - des moyens de détermination du niveau de charge de la batterie en fonction des comparaisons.

Ainsi, la présente invention prend en compte l'hystérésis entre les seuils de charge et de décharge pour déterminer le niveau de charge de la batterie de manière simple sans nécessiter de calculs complexes. La présente invention peut ainsi être exécutée par un dispositif de contrôle qui assure classiquement la fonction de commande du moteur en fonction de consignes générées par l'utilisateur d'un dispositif d'occultation par l'intermédiaire d'un dispositif de pilotage.

Selon un mode particulier, les seuils de charge sont au nombre de quatre et les seuils de décharge sont au nombre de quatre.

La présente invention peut ainsi être exécutée par un dispositif de contrôle qui assure classiquement la fonction de commande du moteur en fonction de consignes générées par l'utilisateur d'un dispositif d'occultation par l'intermédiaire d'un dispositif de pilotage. Selon un mode particulier, le quatrième seuil de charge est en outre déterminé à partir d'une mesure du courant de charge délivré par les éléments photovoltaïques à la batterie. Ainsi, la présente invention permet de générer la charge de la batterie dans un mode dit d'entretien.

Selon un mode particulier, le procédé est exécuté lorsqu'une période de temps est écoulée après un mouvement du moteur et en interrompant la charge de la batterie.

Ainsi, la présente invention limite l'impact des courants de charge et de décharge pour la détermination du niveau de charge de la batterie.

Selon un mode particulier, la batterie est de type Ni-Mh.

L'invention concerne également un programme d'ordinateur pouvant être stocké sur un support et/ou téléchargé d'un réseau de communication, afin d'être lu par un processeur. Ce programme d'ordinateur comprend des instructions pour implémenter le procédé mentionné ci-dessus dans l'un quelconque de ses modes de réalisation, lorsque ledit programme d'ordinateur est exécuté par le processeur.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un exemple d'un système d'occultation d'une ouverture d'une pièce d'un bâtiment ou de protection solaire dans lequel la présente invention est implémentée ;
[Fig. 2] illustre schématiquement un exemple d'un dispositif de contrôle de l'alimentation électrique d'un dispositif d'occultation d'une ouverture d'une pièce d'un bâtiment ou d'une protection solaire ;
[Fig. 3] illustre schématiquement un exemple d'architecture matérielle du contrôleur ;
[Fig. 4] illustre schématiquement des étapes d'un algorithme de détermination d'un niveau de charge d'une batterie alimentant en énergie électrique un dispositif d'occultation d'une ouverture d'une pièce d'un bâtiment ou d'une protection solaire ;
[Fig. 5] illustre schématiquement des étapes d'un algorithme de détermination de seuils utilisés pour déterminer un niveau de charge d'une batterie lorsque le niveau de charge de la batterie est inférieur à 75% de sa capacité ;
[Fig. 6] illustre schématiquement des étapes d'un algorithme de détermination de seuils utilisés pour déterminer un niveau de charge d'une batterie lorsque le niveau de charge de la batterie est de l'ordre de ou supérieur à 75% de sa capacité ;
[Fig. 7] illustre un exemple d'une table utilisée par l'algorithme représenté à la Fig. 6.

### EXPOSE DETAILLE DE MODES DE REALISATION

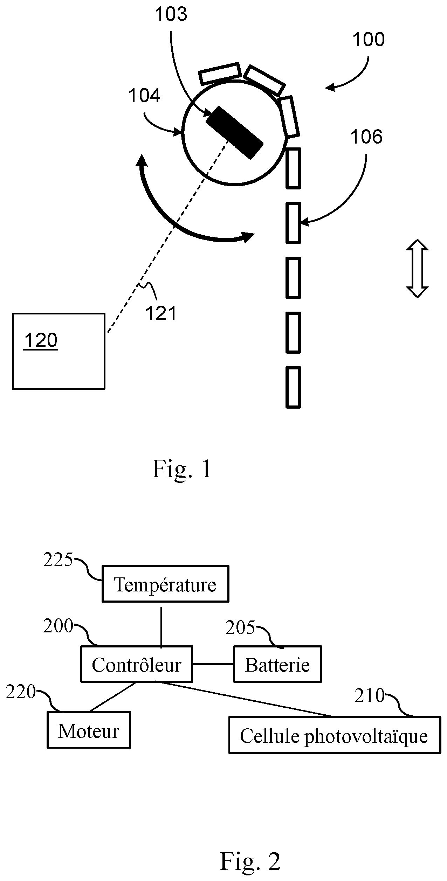

La Fig. 1 illustre ainsi schématiquement un dispositif d'occultation motorisé 100 d'une baie qui est destiné à venir s'installer dans un coffre de volet d'un bâtiment, ledit coffre de volet étant situé au-dessus de la baie à obturer. Le dispositif d'occultation motorisé 100 comprend un tablier 106, et des moyens d'entraînement 103 constitués d'un moteur, d'éléments photovoltaïques, d'une batterie et d'un dispositif de contrôle de l'alimentation électrique du dispositif d'occultation. Le dispositif de contrôle de l'alimentation électrique du dispositif d'occultation assure aussi la fonction de commande du moteur en fonction de consignes générées par l'utilisateur du dispositif d'occultation par l'intermédiaire d'un dispositif de pilotage 120. Le dispositif d'occultation motorisé comporte aussi un tube d'enroulement 104 qui est mis en rotation par le moteur pour entraîner en montée et en descente le tablier 106.

Le moteur est par exemple coaxial avec le tube d'enroulement 104 et est disposé à l'intérieur dudit tube d'enroulement 104. La fixation du tablier 106 sur le tube d'enroulement 104 s'effectue à l'aide d'un dispositif de verrouillage souple ou rigide. Le tube d'enroulement 104 est entraîné en rotation par le moteur 103 et entraîne alors la montée ou la descente du tablier 106 selon que le sens de rotation du tube d'enroulement 104 génère l'enroulement ou le déroulement du tablier 106 autour du tube d'enroulement 104.

Généralement, le tablier 106 est constitué de lattes fixées les unes aux autres de manière à présenter un espace entre elles.

Le moteur 103 est contrôlé par le contrôleur 200 (représenté en Fig. 2) qui permet de piloter la rotation du moteur 103 dans un premier sens ou dans un deuxième sens opposé au premier, de sorte à entraîner la montée ou la descente du tablier 106 et des commandes d'arrêt de la rotation du moteur 103. Le moteur 103 et le contrôleur 200 sont alimentés électriquement par une batterie.

Le contrôleur 200 reçoit des instructions en provenance d'un dispositif de pilotage 120 par le biais d'un lien de communication 121 d'un réseau de communication. Le dispositif de pilotage 120 est un émetteur tel qu'un boîtier dédié ou une télécommande ou un téléphone intelligent, configuré pour émettre des instructions au contrôleur 200. L'émission d'une instruction résulte d'une action exécutée ou programmée par un utilisateur. Le dispositif de pilotage 120 permet ainsi à l'utilisateur de générer l'émission d'instructions vers le contrôleur 200 du moteur 103.

La Fig. 2 illustre schématiquement un exemple d'un dispositif de contrôle de l'alimentation électrique d'un dispositif d'occultation d'une ouverture d'une pièce d'un bâtiment ou d'une protection solaire.

Le dispositif de contrôle de l'alimentation électrique d'un dispositif d'occultation d'une ouverture d'une pièce d'un bâtiment ou d'une protection solaire comporte un contrôleur 200, un capteur de température 225, une batterie 205 et des éléments photovoltaïques 210. Le contrôleur 200 comporte des moyens de mesure de la tension électrique aux bornes de la batterie et/ou des éléments photovoltaïques 210 et du courant délivré par la batterie 205 et/ou par les éléments photovoltaïques 210.

La batterie 205 de capacité C est rechargée par les éléments photovoltaïques 210, par exemple à un courant ≤C/10. La recharge de la batterie est dépendante du flux solaire reçu par les éléments photovoltaïques 210 et la décharge (à un courant ≥ C) de la batterie est liée à la consommation du moteur qui est dépendante de l'utilisation du volet roulant par l'utilisateur. Le niveau de charge initial de la batterie n'est a priori pas connu (batterie neuve reçue avec un niveau de charge dépendant du niveau de charge sortie d'usine du fabricant, du temps de stockage et de la température du stockage qui influe sur l'autodécharge de ce type de batterie).

Par conséquent, dans ce genre de système, la batterie est en permanence chargée ou déchargée de manière indéterminée et non prédictive.

L'inconvénient des batteries de type Ni-Mh est qu'elles présentent une hystérésis de tension en charge dépendant du courant et de la température.

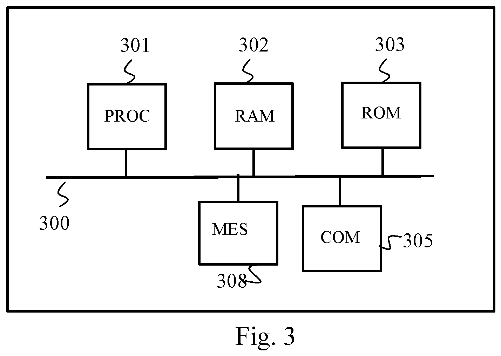

La Fig. 3 illustre schématiquement un exemple d'architecture matérielle du contrôleur.

Le contrôleur 200 comporte, reliés par un bus de communication 300 : un processeur ou CPU (« Central Processing Unit » en anglais) 301 ; une mémoire vive RAM (« Random Access Memory » en anglais) 302 ; une mémoire morte ROM (« Read Only Memory » en anglais) 303 ; une interface de communication 305 permettant de communiquer avec le dispositif de pilotage 120 et une unité de mesure 308 permettant d'obtenir des mesures de la température, de la tension électrique aux bornes de la batterie 205 et/ou des éléments photovoltaïques 210 et du courant délivré par la batterie 205 et/ou des éléments photovoltaïques 210.

Le processeur 301 est capable d'exécuter des instructions chargées dans la RAM 302 à partir de la ROM 303.Lorsque le contrôleur 200 est mis sous tension, le processeur 301 est capable de lire de la RAM 302 des instructions et de les exécuter.

Ces instructions forment un programme d'ordinateur causant l'implémentation, par le processeur 301, de tout ou partie des algorithmes et étapes décrits ci-après.

Ainsi, tout ou partie des algorithmes et étapes décrits ci-après peut être implémenté sous forme logicielle par exécution d'un ensemble d'instructions par une machine programmable, telle qu'un DSP (« Digital Signal Processor » en anglais) ou un microcontrôleur, ou sous forme matérielle par une machine ou un composant dédié, tel qu'un FPGA (« Field-Programmable Gate Array » en anglais) ou un ASIC (« Application-Specific Integrated Circuit » en anglais).

Le dispositif de pilotage 120 comporte une interface homme machine permettant de commander le dispositif d'occultation et des moyens de visualisation du niveau de charge de la batterie 205.

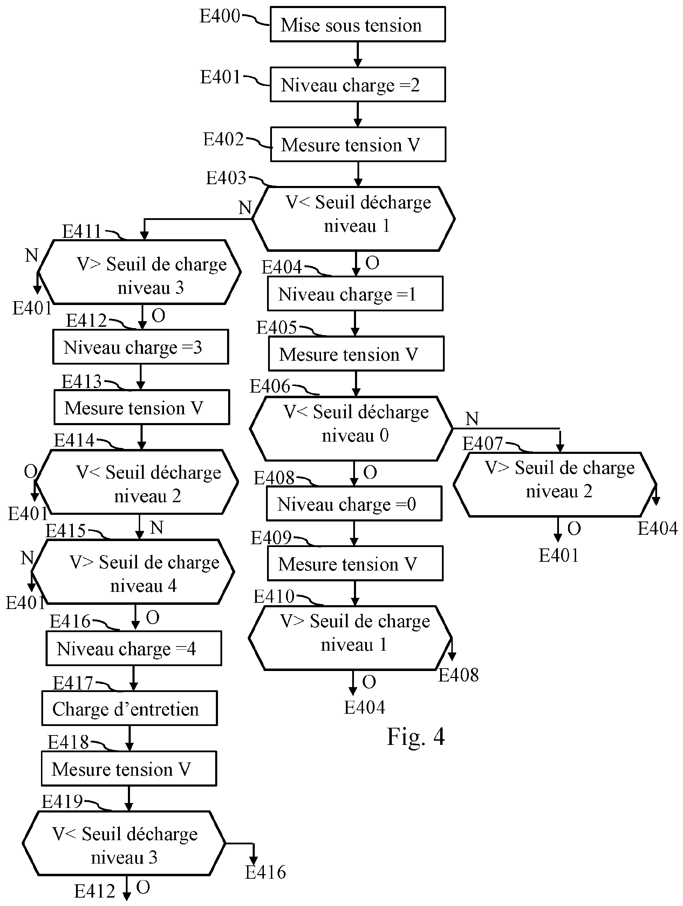

La Fig. 4 illustre schématiquement des étapes d'un algorithme de détermination d'un niveau de charge d'une batterie alimentant en énergie électrique un dispositif d'occultation d'une ouverture d'une pièce d'un bâtiment ou d'une protection solaire.

Pour limiter l'impact des courants de charge et de décharge, le présent algorithme effectue une mesure de tension à vide de la batterie au moins 10 mn après un mouvement du moteur et en coupant la charge de la batterie pendant ces 10 mn.

Par exemple, le présent algorithme est exécuté avec une périodicité de l'ordre de deux heures pour rafraîchir le niveau de charge de la batterie et prendre en compte les courant d'autodécharge du système.

Le présent algorithme est décrit dans un exemple dans lequel il est exécuté par le contrôleur 200.

A l'étape E400, le contrôleur 200 est mis sous tension.

A l'étape E401, le contrôleur 200 met la variable niveau de charge égale à la valeur 2.

A l'étape E402, le contrôleur 200 obtient une mesure de la tension notée V de la batterie 205.

A l'étape E403, le contrôleur 200 vérifie si la tension mesurée V est inférieure à un seuil de décharge de la batterie de niveau 1.

Le seuil de décharge de niveau 1 de la batterie est par exemple égal à 12,1 Volts.

Dans l'affirmative, le contrôleur 200 passe à l'étape E404. Dans la négative, le contrôleur 200 passe à l'étape E411.

A l'étape E404, le contrôleur 200 met la variable niveau de charge égale à la valeur 1.

A l'étape E405, le contrôleur 200 obtient une mesure de la tension notée V de la batterie 205.

A l'étape E406, le contrôleur 200 vérifie si la tension mesurée V est inférieure à un seuil de décharge de la batterie de niveau 0.

Le seuil de décharge de niveau 0 de la batterie est par exemple égal à 11,5Volts.

Dans l'affirmative, le contrôleur 200 passe à l'étape E408. Dans la négative, le contrôleur 200 passe à l'étape E407.

A l'étape E407, le contrôleur 200 vérifie si la tension mesurée V est supérieure à un seuil de charge de la batterie de niveau 2.

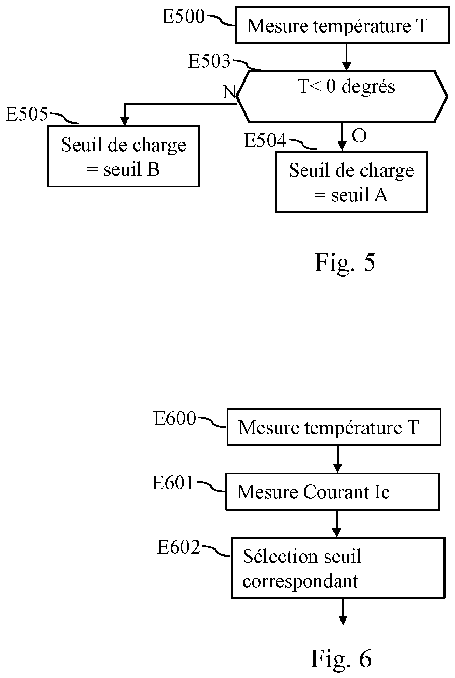

Le seuil de charge de niveau 2 de la batterie est par exemple égal à 13,8 Volts lorsque la température mesurée est supérieure à 0°C et égal à 14,3 Volts lorsque la température mesurée est inférieure à égale à 0°C. La valeur du seuil de charge de niveau 2 de la batterie est déterminée par l'algorithme qui sera décrit en référence à la Fig. 5.

Dans l'affirmative, le contrôleur 200 passe à l'étape E401. Dans la négative, le contrôleur 200 passe à l'étape E404.

A l'étape E408, le contrôleur 200 met la variable niveau de charge égale à la valeur 0.

A l'étape E409, le contrôleur 200 obtient une mesure de la tension notée V de la batterie 205.

A l'étape E410, le contrôleur 200 vérifie si la tension mesurée V est supérieure à un seuil de charge de la batterie de niveau 1.

Le seuil de charge de niveau 1 de la batterie est par exemple égal à 13,3 Volts lorsque la température mesurée est supérieure à 0°C et égal à 14 Volts lorsque la température mesurée est inférieure à égale à 0°C. La valeur du seuil de charge de niveau 1 de la batterie est déterminée par l'algorithme qui sera décrit en référence à la Fig. 5.

Dans l'affirmative, le contrôleur 200 passe à l'étape E404. Dans la négative, le contrôleur 200 passe à l'étape E408.

A l'étape E411, le contrôleur 200 vérifie si la tension mesurée V est supérieure à un seuil de charge de la batterie de niveau 3.

Le seuil de charge de niveau 3 de la batterie est par exemple égal à 14,2 Volts lorsque la température mesurée est supérieure à 0°C et égal à 14,7 Volts lorsque la température mesurée est inférieure à égale à 0°C. La valeur du seuil de charge de niveau 3 de la batterie est déterminée par l'algorithme qui sera décrit en référence à la Fig. 5.

Dans l'affirmative, le contrôleur 200 passe à l'étape E412. Dans la négative, le contrôleur 200 passe à l'étape E401.

A l'étape E412, le contrôleur 200 met la variable niveau de charge égale à la valeur 3.

A l'étape E413, le contrôleur 200 obtient une mesure de la tension notée V de la batterie 205.

A l'étape E414, le contrôleur 200 vérifie si la tension mesurée V est inférieure à un seuil de décharge de la batterie de niveau 2.

Le seuil de décharge de niveau 2 de la batterie est par exemple égal à 12,4 Volts.

Dans l'affirmative, le contrôleur 200 passe à l'étape E401. Dans la négative, le contrôleur 200 passe à l'étape E415.

A l'étape E415, le contrôleur 200 vérifie si la tension mesurée V est supérieure à un seuil de charge de la batterie de niveau 4.

Le seuil de charge de niveau 4 de la batterie est déterminé par l'algorithme qui sera décrit en référence à la Fig. 6.

Dans l'affirmative, le contrôleur 200 passe à l'étape E416. Dans la négative, le contrôleur 200 passe à l'étape E401.

A l'étape E416, le contrôleur 200 met la variable niveau de charge égale à la valeur 4.

A l'étape E417, le contrôleur 200 se met dans un mode dit de charge d'entretien.

Le mode charge d'entretien permet de finaliser la charge de la batterie 205 et de compenser l'autodécharge de batterie 205 ainsi que la consommation de veille du dispositif de contrôle. La charge d'entretien est réalisée de la façon suivante : la batterie est chargée avec un rapport cyclique de 10% du temps (1mm de charge toutes les 10 mn).

A l'étape E418, le contrôleur 200 obtient une mesure de la tension notée V de la batterie 205.

A l'étape E419, le contrôleur 200 vérifie si la tension mesurée V est inférieure à un seuil de décharge de la batterie de niveau 3.

Le seuil de charge de niveau 1 de la batterie est par exemple égal à 12,7 Volts.

Dans l'affirmative, le contrôleur 200 passe à l'étape E412. Dans la négative, le contrôleur 200 passe à l'étape E416.

A la fin de l'exécution de l'algorithme de la Fig. 4, le contrôleur 200 met à disposition du dispositif de pilotage 120 une information représentative du niveau de charge déterminé. Le niveau de charge déterminé est représenté visuellement sur le dispositif de pilotage 120 par exemple sous la forme de barrettes. Aucune barrette ne correspond au niveau de charge 0, une barrette correspond au niveau de charge 1, deux barrettes correspondent au niveau de charge 2, trois barrettes correspondent au niveau de charge 3 et quatre barrettes correspondent au niveau de charge 4.

La Fig. 5 illustre schématiquement des étapes d'un algorithme de détermination de seuils utilisés pour déterminer un niveau de charge d'une batterie lorsque le niveau de charge de la batterie est inférieur à 75% de sa capacité.

Par exemple, le présent algorithme est exécuté avec une périodicité de l'ordre de deux heures.

Le présent algorithme est décrit dans un exemple dans lequel il est exécuté par le contrôleur 200.

A l'étape E500, le contrôleur 200 obtient une mesure de la température notée T.

La température T est la température dans un coffre comprenant le dispositif de contrôle de l'alimentation électrique du dispositif d'occultation de l'ouverture ou de la protection solaire. La température T est sensiblement égale à la température de la batterie. La température T est mesurée lorsque le moteur 220 n'est pas en rotation.

A l'étape E503, le contrôleur 200 vérifie si la température T est inférieure ou égale à une température prédéterminée, par exemple 0 degré Celsius.

Dans l'affirmative, le contrôleur 200 met à l'étape E504 les seuils de charge de niveau 1, 2 et 3 aux valeurs respectives de 14 Volts, 14,3 Volts et 14,7 Volts.

Dans la négative, le contrôleur 200 met à l'étape E505 les seuils de charge de niveau 1, 2 et 3 aux valeurs respectives de 13,5 Volts, 13,8 Volts et 14,2 Volts.

La Fig. 6 illustre schématiquement des étapes d'un algorithme de détermination de seuils utilisés pour déterminer un niveau de charge d'une batterie lorsque le niveau de charge de la batterie est de l'ordre de ou supérieur à 75% de sa capacité.

A l'étape E600, le contrôleur 200 obtient une mesure de la température notée T.

A l'étape E601, le contrôleur 200 obtient une mesure du courant de charge Ic délivré par les éléments photovoltaïques 210 à la batterie 205.

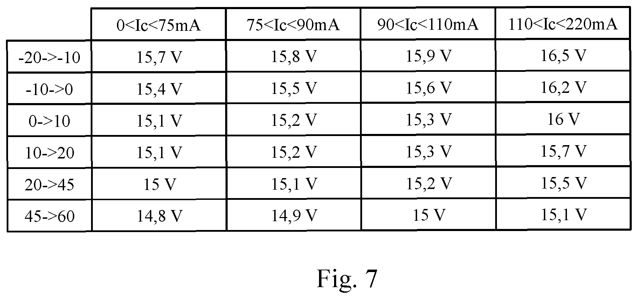

A l'étape E602, le contrôleur 200 sélectionne le seuil de charge de la batterie de niveau 4 qui correspond au courant Ic et à la température T mesurés dans la table telle que représentée en Fig. 7.

La Fig. 7 illustre un exemple d'une table utilisée par l'algorithme représenté à la Fig. 6.

La table de la Fig. 7 comporte 6 lignes.

Une première ligne comporte différentes valeurs du seuil de charge de la batterie de niveau 4 pour une température comprise entre -20 et -10 degrés Celsius.

Une seconde ligne comporte différentes valeurs du seuil de charge de la batterie de niveau 4 pour une température comprise entre -10 et 0 degrés Celsius.

Une troisième ligne comporte différentes valeurs du seuil de charge de la batterie de niveau 4 pour une température comprise entre 0 et 10 degrés Celsius.

Une quatrième ligne comporte différentes valeurs du seuil de charge de la batterie de niveau 4 pour une température comprise entre 10 et 20 degrés Celsius.

Une cinquième ligne comporte différentes valeurs du seuil de charge de la batterie de niveau 4 pour une température comprise entre 20 et 45 degrés Celsius.

Une sixième ligne comporte différentes valeurs du seuil de charge de la batterie de niveau 4 pour une température comprise entre 45 et 60 degrés Celsius.

La table de la Fig. 7 comporte 4 colonnes.

Une première colonne comporte différentes valeurs du seuil de charge de la batterie de niveau 4 pour un courant Ic compris entre 0 et 75 milliampères.

Une seconde colonne comporte différentes valeurs du seuil de charge de la batterie de niveau 4 pour un courant Ic compris entre 75 et 90 milliampères.

Une troisième colonne comporte différentes valeurs du seuil de charge de la batterie de niveau 4 pour un courant Ic compris entre 90 et 110 milliampères.

Une quatrième colonne comporte différentes valeurs du seuil de charge de la batterie de niveau 4 pour un courant Ic compris entre 110 et 220 milliampères.

## Revendications

1. Procédé de détermination d'un niveau de charge d'une batterie alimentant en énergie électrique un dispositif d'occultation d'une ouverture d'une pièce d'un bâtiment ou d'une protection solaire, la batterie étant alimentée en énergie électrique par des éléments photovoltaïques, **caractérisé en ce que** le procédé comporte les étapes effectuées par un dispositif de contrôle de l'alimentation électrique du dispositif d'occultation de l'ouverture ou de la protection solaire de :
- mesure d'une température dans un coffre comprenant le dispositif de contrôle de l'alimentation électrique,
- vérification si la température mesurée est inférieure ou égale à une unique température prédéterminée,
- détermination d'une pluralité de valeurs de seuils de charge de la batterie en fonction de la vérification,
- mesure (E402) d'une tension aux bornes de la batterie,
- comparaisons (E403, E406, E407, E410, E411, E414, E415 E419) de la tension mesurée à au moins une partie des seuils de charge et/ou à des seuils de décharge de la batterie, les seuils de décharge de la batterie ayant des valeurs prédéterminées et indépendantes de la température mesurée,
- détermination du niveau de charge (E410, E404, E408, E412, E416) de la batterie en fonction des comparaisons.

2. Procédé selon la revendication 1, **caractérisé en ce que** les seuils de charge sont au nombre de quatre et les seuils de décharge sont au nombre de quatre.

3. Procédé selon la revendication 2, **caractérisé en ce que** le quatrième seuil de charge est en outre déterminé à partir d'une mesure du courant de charge délivré par les éléments photovoltaïques à la batterie.

4. Procédé selon l'une quelconque des revendications précédentes, **caractérisé en ce que** le procédé est exécuté lorsqu'une période de temps est écoulée après un mouvement du moteur et en interrompant la charge de la batterie.

5. Procédé selon l'une quelconque des revendications précédentes, **caractérisé en ce que** la batterie est de type Ni-Mh.

6. Dispositif de détermination d'un niveau de charge d'une batterie alimentant en énergie électrique un dispositif d'occultation d'une ouverture d'une pièce d'un bâtiment ou d'une protection solaire, la batterie étant alimentée en énergie électrique par des éléments photovoltaïques, **caractérisé en ce que** le dispositif est compris dans un dispositif de contrôle de l'alimentation électrique du dispositif d'occultation de l'ouverture ou de la protection solaire et comporte :
- des moyens de mesure d'une température dans un coffre comprenant le dispositif de contrôle de l'alimentation électrique,
- des moyens de vérification si la température mesurée est inférieure ou égale à une unique température prédéterminée,
- des moyens de détermination d'une pluralité de valeurs de seuils de charge de la batterie en fonction de la vérification,
- des moyens de mesure d'une tension aux bornes de la batterie,
- des moyens de comparaisons de la tension mesurée à au moins une partie des seuils de charge et/ou à des seuils de décharge de la batterie, les seuils de décharge de la batterie ayant des valeurs prédéterminées et indépendantes de la température mesurée,
- des moyens de détermination du niveau de charge de la batterie en fonction des comparaisons.

## Patentansprüche

1. Verfahren zur Bestimmung eines Ladezustands einer Batterie, die eine Vorrichtung zur Verdunkelung einer Öffnung eines Zimmers eines Gebäudes oder eines Sonnenschutzes mit elektrischer Energie versorgt, wobei die Batterie von Photovoltaikelementen mit elektrischer Energie versorgt wird, **dadurch gekennzeichnet, dass** das Verfahren die folgenden Schritte beinhaltet, die von einer Vorrichtung zur Steuerung der Stromversorgung der Vorrichtung zur Verdunkelung der Öffnung oder des Sonnenschutzes durchgeführt werden:
- Messen einer Temperatur in einem Kasten, der die Vorrichtung zur Steuerung der Stromversorgung umfasst,
- Überprüfen, ob die gemessene Temperatur kleiner als oder gleich einer vorbestimmten einzelnen Temperatur ist,
- Bestimmen einer Mehrzahl von Ladeschwellenwerten der Batterie je nach der Überprüfung,
- Messen (E402) einer Spannung an den Anschlüssen der Batterie,
- Vergleichen (E403, E406, E407, E410, E411, E414, E415 E419) der gemessenen Spannung mit wenigstens einigen der Ladeschwellen und/oder mit Entladeschwellen der Batterie, wobei die Entladeschwellen der Batterie vorbestimmte und von der gemessenen Temperatur unabhängige Werte aufweisen,
- Bestimmen des Ladezustands (E410, E404, E408, E412, E416) der Batterie je nach den Vergleichen.

2. Verfahren nach Anspruch 1, **dadurch gekennzeichnet, dass** vier Ladeschwellen und vier Entladeschwellen vorhanden sind.

3. Verfahren nach Anspruch 2, **dadurch gekennzeichnet, dass** die vierte Ladeschwelle ferner anhand einer Messung des Ladestroms bestimmt wird, der von den Photovoltaikelementen an die Batterie geliefert wird.

4. Verfahren nach einem der vorhergehenden Ansprüche, **dadurch gekennzeichnet, dass** das Verfahren ausgeführt wird, wenn eine Zeitspanne nach einer Bewegung des Motors verstrichen ist und indem das Laden der Batterie unterbrochen wird.

5. Verfahren nach einem der vorhergehenden Ansprüche, **dadurch gekennzeichnet, dass** die Batterie vom Typ Ni-Mh ist.

6. Vorrichtung zur Bestimmung eines Ladezustands einer Batterie, die eine Vorrichtung zur Verdunkelung einer Öffnung eines Zimmers eines Gebäudes oder eines Sonnenschutzes mit elektrischer Energie versorgt, wobei die Batterie von Photovoltaikelementen mit elektrischer Energie versorgt wird, **dadurch gekennzeichnet, dass** die Vorrichtung in einer Vorrichtung zur Steuerung der Stromversorgung der Vorrichtung zur Verdunkelung der Öffnung oder des Sonnenschutzes enthalten ist und Folgendes beinhaltet:
- Mittel zum Messen einer Temperatur in einem Kasten, der die Vorrichtung zur Steuerung der Stromversorgung umfasst,
- Mittel zum Überprüfen, ob die gemessene Temperatur kleiner als oder gleich einer vorbestimmten einzelnen Temperatur ist,
- Mittel zum Bestimmen einer Mehrzahl von Ladeschwellenwerten der Batterie je nach der Überprüfung,
- Mittel zum Messen einer Spannung an den Anschlüssen der Batterie,
- Mittel zum Vergleichen der gemessenen Spannung mit wenigstens einigen der Ladeschwellen und/oder mit Entladeschwellen der Batterie, wobei die Entladeschwellen der Batterie vorbestimmte und von der gemessenen Temperatur unabhängige Werte aufweisen,
- Mittel zum Bestimmen des Ladezustands der Batterie je nach den Vergleichen.

## Claims

1. Method for determining a level of charge of a battery supplying electrical energy to a device for shading an opening in a room in a building or solar protection, the battery being supplied with electrical energy by photovoltaic elements, **characterised in that** the method comprises the steps, performed by a device for controlling the electrical supply to the device for shading the opening or the solar protection, of
- measuring a temperature in a box comprising the electrical-supply control device,
- checking whether the measured temperature is less than or equal to a predetermined unique temperature,
- determining a plurality of battery-charging threshold values according to the check,
- measuring (E402) a voltage at the terminals of the battery,
- comparing (E403, E406, E407, E410, E 411, E414, E415, E419) the measured voltage with at least some of the charging thresholds and/or with discharging thresholds of the battery, the discharging thresholds of the battery having predetermined values independent of the measured temperature,
- determining the level of charge (E410, E404, E408, E412, E416) of the battery according to the comparisons.

2. Method according to claim 1, **characterised in that** the charging thresholds are four in number and the discharging thresholds are four in number.

3. Method according to claim 2, **characterised in that** the fourth charging threshold is furthermore determined from a measurement of the charging current delivered by the photovoltaic elements to the battery.

4. Method according to any one of the preceding claims, **characterised in that** the method is implemented when a period of time has elapsed after a movement of the motor and by interrupting the charging of the battery.

5. Method according to any one of the preceding claims, **characterised in that** the battery is of the Ni-MH type.

6. Device for determining a level of charge of a battery supplying electrical energy to a device for shading an opening in a room in a building or solar protection, the battery being supplied with electrical energy by photovoltaic elements, **characterised in that** the device is included in a device for controlling the electrical supply to the device for shading the opening or the solar protection and comprises:
- means for measuring a temperature in a box comprising the electrical-supply control device,
- means for checking whether the measured temperature is less than or equal to a predetermined unique temperature,
- means for determining a plurality of battery-charging threshold values according to the check,
- means for measuring a voltage at the terminals of the battery,
- means for comparing the measured voltage with at least some of the charging thresholds and/or with discharging thresholds of the battery, the discharging thresholds of the battery having predetermined values independent of the measured temperature,
- means for determining the level of charge of the battery according to the comparisons.
